# EUROPEAN PATENT APPLICATION

(11) **EP 4 760 776 A1**
(43) Date of publication of application: **17.06.2026**
(21) Application number: 25175726.6
(22) Date of filing: 12.05.2025
(51) Int. Cl.: H01L 21/20

(54) **EPITAXIAL STRUCTURE, POWER DEVICE AND MANUFACTURING METHOD OF EPITAXIAL STRUCTURE**

(30) Priority: 12.12.2024 TW 113148427
(71) Applicant: Taiwan-Asia Semiconductor Corporation, Hsinchu City 30078 (TW)
(72) Inventor: HSIEH, Po-Jen, 30078 Hsinchu City (TW); LI, Chun-Chieh, 30078 Hsinchu City (TW); CHIANG, Pin-Feng, 30078 Hsinchu City (TW)
(74) Representative: Michalski Hüttermann & Partner mbB

(57) **Abstract**

An epitaxial structure is provided. The epitaxial structure mainly comprises two transition layers, an aluminum-containing transition layer, a gallium-containing transition layer, and a buffer layer therebetween. The aluminum-containing transition layer is disposed on a silicon substrate and includes an aluminum-containing three-dimensional structure and an aluminum-containing two-dimensional structure. The aluminum-containing three-dimensional structure is formed on the silicon substrate and grown transitionally to partially form the aluminum-containing two-dimensional structure. The gallium-containing transition layer is disposed on the buffer layer and includes a gallium-containing three-dimensional structure and a gallium-containing two-dimensional structure. The gallium-containing three-dimensional structure is formed on the buffer layer and grown transitionally to partially form the gallium-containing two-dimensional structure. By means of two three-dimensional to two-dimensional transition layers, the lattice difference between the silicon substrate and the epitaxial layer can be released and the internal stress can be reduced.

## Description

### CROSS-REFERENCES TO RELATED APPLICATIONS

This application claims the benefit of priority to Taiwanese Patent Application No. 113148427 filed on December 12, 2024, which is hereby incorporated by reference in its entirety.

### BACKGROUND OF THE INVENTION

### Field of the Invention

The present invention relates to an epitaxial structure, a power device, and a method for manufacturing an epitaxial structure, and in particular to a gallium nitride (GaN) epitaxial structure, a gallium nitride power device, and a method for manufacturing a gallium nitride epitaxial structure.

### Descriptions of the Related Art

In recent years, with advancements in materials and structures, high electron mobility transistors (HEMTs) have achieved significant development, especially in applications for power electronics and high-frequency devices. HEMTs primarily utilize the wide bandgap properties of gallium nitride (GaN) materials, which can generate a two-dimensional electron gas (2DEG) at heterojunctions. This enables high breakdown voltage, excellent electron mobility, and low on-resistance, resulting in superior device performance with high switching speeds and power density.

However, the fabrication of gallium nitride epitaxial substrates faces numerous technical challenges and difficulties, primarily related to material properties, growth processes, and substrate selection. Specifically, there is a significant lattice mismatch between the lattice constant of gallium nitride and commonly used substrates (e.g., sapphire, silicon, or silicon carbide). For instance, the lattice mismatch between gallium nitride and sapphire is approximately 16%, and with silicon, it reaches up to 17%. Such lattice mismatches lead to the formation of high-density dislocations, typically ranging from 10⁹ to 10¹⁰ cm⁻², which degrade the performance of high electron mobility transistors. In view of this, there is an urgent need in the industry for an innovative epitaxial structure to overcome the challenges in epitaxial manufacturing that affect the performance of next-generation wide-bandgap semiconductor devices.

### SUMMARY OF THE INVENTION

The main objective of the present invention is to provide an epitaxial structure, a power device, and a method for manufacturing an epitaxial structure. This epitaxial structure features two transition layers: an aluminum-containing transition layer and a gallium-containing transition layer. By employing two transition layers that shift from three-dimensional to two-dimensional structures with different materials, the significant lattice mismatch between a silicon wafer and a gallium nitride epitaxial layer is adjusted, reducing internal lattice stress, improving the yield of mass-produced epitaxial wafers, and enhancing the epitaxial quality and electrical performance of the channel layer in the device.

To achieve the above objective, the present invention provides an epitaxial structure comprising an aluminum-containing transition layer, an aluminum-containing homogeneous layer, a first buffer layer, a gallium-containing transition layer, a gallium-containing homogeneous layer, and a second buffer layer. The aluminum-containing transition layer is disposed on a substrate and includes an aluminum-containing three-dimensional structure and an aluminum-containing two-dimensional structure, wherein the aluminum-containing three-dimensional structure is formed on the substrate and grown to partially transition into the aluminum-containing two-dimensional structure. The aluminum-containing homogeneous layer is disposed on the aluminum-containing two-dimensional structure, and the first buffer layer is disposed on the aluminum-containing homogeneous layer. The gallium-containing transition layer is disposed on the first buffer layer and includes a gallium-containing three-dimensional structure and a gallium-containing two-dimensional structure, wherein the gallium-containing three-dimensional structure is formed on the first buffer layer and grown to partially transition into the gallium-containing two-dimensional structure. The gallium-containing homogeneous layer is disposed on the gallium-containing two-dimensional structure, and the second buffer layer is disposed on the gallium-containing homogeneous layer.

In one embodiment of the epitaxial structure of the present invention, the epitaxial structure further comprises a plurality of aluminum-containing seeds disposed on the substrate, wherein the aluminum-containing three-dimensional structure is grown and formed from these aluminum-containing seeds.

In one embodiment of the epitaxial structure of the present invention, each of the aluminum-containing seeds is an aluminum nitride (AlN) seed.

In one embodiment of the epitaxial structure of the present invention, the aluminum-containing transition layer is an aluminum nitride transition layer with a thickness of 10 to 20 nanometers (nm).

In one embodiment of the epitaxial structure of the present invention, the aluminum-containing homogeneous layer is an aluminum nitride layer with a thickness of 30 to 300 nanometers (nm).

In one embodiment of the epitaxial structure of the present invention, the material of the first buffer layer is made by aluminum (Al), gallium (Ga), and nitrogen (N), with a thickness of 20 to 5000 nanometers (nm).

In one embodiment of the epitaxial structure of the present invention, the epitaxial structure further comprises a plurality of gallium-containing seeds disposed on the first buffer layer, wherein the gallium-containing three-dimensional structure is grown and formed from these gallium-containing seeds.

In one embodiment of the epitaxial structure of the present invention, each of the gallium-containing seeds is a gallium nitride (GaN) seed.

In one embodiment of the epitaxial structure of the present invention, the gallium-containing transition layer is a gallium nitride transition layer with a thickness of 10 to 20 nanometers (nm).

In one embodiment of the epitaxial structure of the present invention, the gallium-containing homogeneous layer is a gallium nitride layer with a thickness of 30 to 300 nanometers (nm).

In one embodiment of the epitaxial structure of the present invention, the material of the second buffer layer is made by aluminum (Al), gallium (Ga), and nitrogen (N), with a thickness of 20 to 5000 nanometers (nm).

To achieve the above objective, the present invention provides a power device comprising a substrate, an epitaxial structure as described above disposed on the substrate, and a channel layer disposed on the epitaxial structure, wherein the channel layer includes a two-dimensional electron gas (2DEG) channel therein.

To achieve the above objective, the present invention provides a method for manufacturing an epitaxial structure, comprising the following steps. First, an aluminum-containing transition layer is formed on a substrate, wherein the aluminum-containing transition layer includes an aluminum-containing three-dimensional structure and an aluminum-containing two-dimensional structure, the aluminum-containing three-dimensional structure is formed on the substrate and grown to partially transition into the aluminum-containing two-dimensional structure. Next, an aluminum-containing homogeneous layer is formed on the aluminum-containing two-dimensional structure and a first buffer layer is formed on the aluminum-containing homogeneous layer. Then, a gallium-containing transition layer is formed on the first buffer layer, wherein the gallium-containing transition layer includes a gallium-containing three-dimensional structure and a gallium-containing two-dimensional structure, the gallium-containing three-dimensional structure is formed on the first buffer layer and grown to partially transition into the gallium-containing two-dimensional structure. Finally, a gallium-containing homogeneous layer is formed on the gallium-containing two-dimensional structure and a second buffer layer is formed on the gallium-containing homogeneous layer.

In one embodiment of the manufacturing method of the epitaxial structure of the present invention, the manufacturing method further comprises a step of providing a plurality of aluminum nitride seeds on the substrate, wherein the aluminum-containing three-dimensional structure is grown and formed from these aluminum nitride seeds.

In one embodiment of the manufacturing method of the epitaxial structure of the present invention, the step of forming an aluminum-containing transition layer is to form an aluminum nitride transition layer with a thickness of 10 to 20 nanometers (nm).

In one embodiment of the manufacturing method of the epitaxial structure of the present invention, the step of forming an aluminum-containing homogeneous layer is to form an aluminum nitride layer with a thickness of 30 to 300 nanometers (nm).

In one embodiment of the manufacturing method of the epitaxial structure of the present invention, it further comprises a step of providing a plurality of gallium nitride seeds on the first buffer layer, wherein the gallium-containing three-dimensional structure is grown and formed from these gallium nitride seeds.

In one embodiment of the manufacturing method of the epitaxial structure of the present invention, the step of forming a gallium-containing transition layer is to form a gallium nitride transition layer with a thickness of 10 to 20 nanometers (nm).

In one embodiment of the manufacturing method of the epitaxial structure of the present invention, the step of forming a gallium-containing homogeneous layer is to form a gallium nitride layer with a thickness of 30 to 300 nanometers (nm).

After referring to the drawings and the embodiments described subsequently, those skilled in the art will understand the other objectives of the present invention, as well as the technical means and embodiments of the present invention.

### BRIEF DESCRIPTION OF THE DRAWINGS

FIG. 1A to FIG. 1I are schematic diagrams illustrating the manufacturing process of an epitaxial structure according to an embodiment of the present invention;
FIG. 2 is a magnified scanning electron microscope (SEM) image of an epitaxial structure according to an embodiment of the present invention;
FIG. 3 is a schematic diagram of an epitaxial structure according to another embodiment of the present invention;
FIG. 4 is a schematic diagram of a power device utilizing an epitaxial structure according to an embodiment of the present invention; and
FIG. 5 is a schematic diagram of the process steps for manufacturing an epitaxial structure according to the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

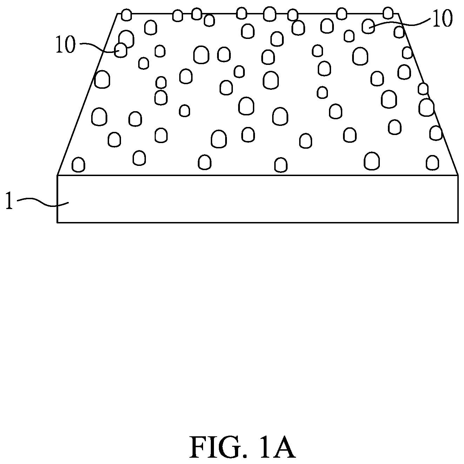

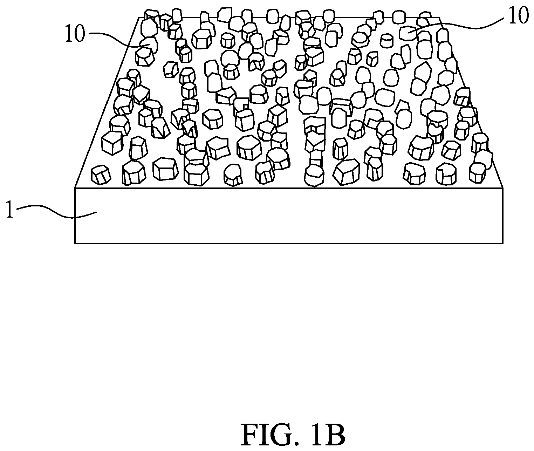

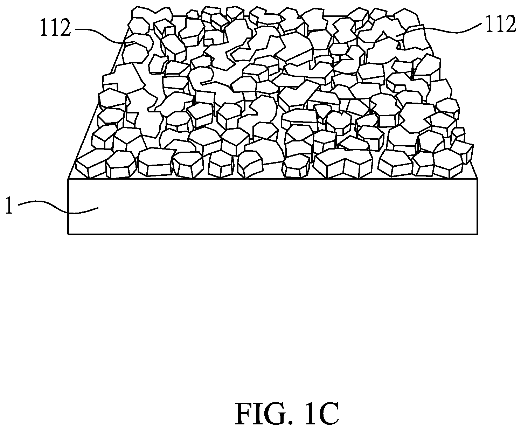

The present invention discloses an epitaxial structure suitable for power devices and a method for manufacturing the same, thereby improving the performance of power devices. Referring to FIG. 1A, first, a plurality of aluminum-containing seeds 10 are provided on a substrate 1. The substrate 1 may be a silicon (Si) substrate, a silicon-on-insulator (SOI) substrate, or the like, but is not limited thereto. For example, using metal-organic chemical vapor deposition (MOCVD), ammonia (NH₃) and trimethylaluminum (TMAl) gases are introduced to slowly form a plurality of aluminum nitride (AlN) seeds uniformly distributed on the <111> crystal plane of the silicon substrate. Then, at a low temperature of 400 to 600°C, the aluminum-containing seeds 10 continue to grow, increasing their volume, as shown in FIG. 1B. After a period of growth, due to the significant lattice constant mismatch and high dislocation density between the silicon substrate and aluminum nitride, aluminum nitride cannot form a flat thin film on the substrate and instead forms numerous island-like aluminum-containing three-dimensional structures 112, as shown in FIG. 1C. This stage is defined as the "3D growth" stage.

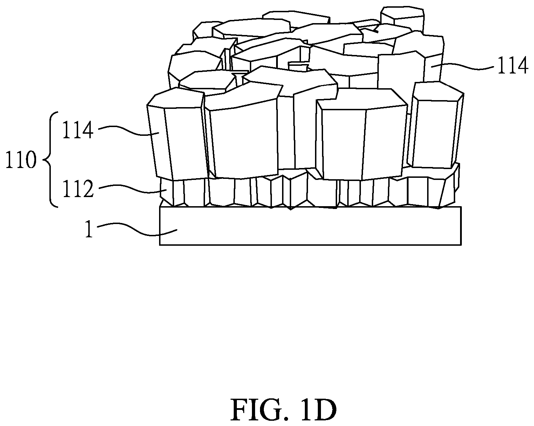

Next, the growth temperature is raised to a high temperature of 1000 to 1200°C. At this point, aluminum and nitrogen atoms gain sufficient kinetic energy to move along the substrate surface to the most suitable lattice positions, resulting in a lateral growth rate exceeding the vertical growth rate. This causes the island-like aluminum-containing three-dimensional structures 112 to grow larger, entering what is referred to as the "2D growth" stage. As the island-like aluminum-containing three-dimensional structures 112 grow laterally to a certain extent, they begin to coalesce with adjacent island-like structures. Once all the island-like structures merge into a block and combine, the crystal surface becomes flat, and the aluminum-containing three-dimensional structures 112 begin to grow upward, partially forming an aluminum-containing two-dimensional structure 114, as shown in FIG. 1D. At this point, an aluminum-containing transition layer 110 is formed on the substrate 1, comprising the aluminum-containing three-dimensional structure 112 formed on the substrate 1 and the aluminum-containing two-dimensional structure 114 partially transitioned from the growth of the aluminum-containing three-dimensional structure 112. Specifically, the aluminum-containing transition layer 110 is an aluminum nitride transition layer with a thickness of 10 to 20 nanometers (nm), significantly adjusting lattice dislocations as the lattice of silicon on the substrate transitions from a three-dimensional to a two-dimensional structure through aluminum nitride.

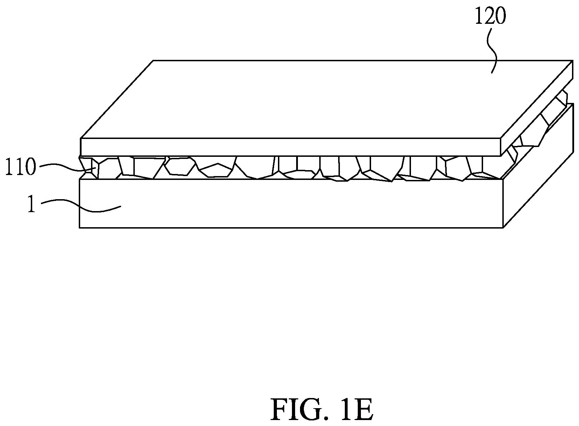

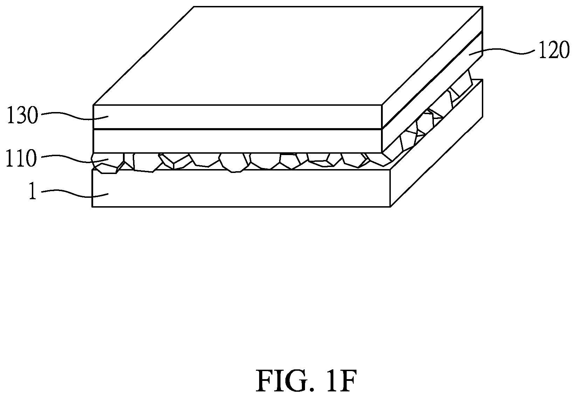

Referring to FIG. 1E, an aluminum-containing homogeneous layer 120 is then grown on the flat surface of the aluminum-containing two-dimensional structure 114 of the aluminum-containing transition layer 110. This aluminum-containing homogeneous layer is specifically an aluminum nitride layer with a thickness of at least 30 to 300 nanometers (nm), stabilizing defects in the aluminum nitride material. Referring to FIG. 1F, a first buffer layer 130 is then formed on the aluminum-containing homogeneous layer 120 to further modulate internal stress. The first buffer layer 130 may be a bulk structure or a layered stack structure, such as a layered stack made by aluminum (Al), gallium (Ga), and nitrogen (N) in varying proportions. Specifically, it may be a superlattice structure alternating stacked between high-bandgap materials (e.g., aluminum nitride or high-aluminum-content aluminum gallium nitride) and low-bandgap materials (e.g., gallium nitride or low-aluminum-content aluminum gallium nitride), with a total thickness of 20 to 5000 nanometers (nm), further reducing internal stress and defect density caused by lattice mismatch.

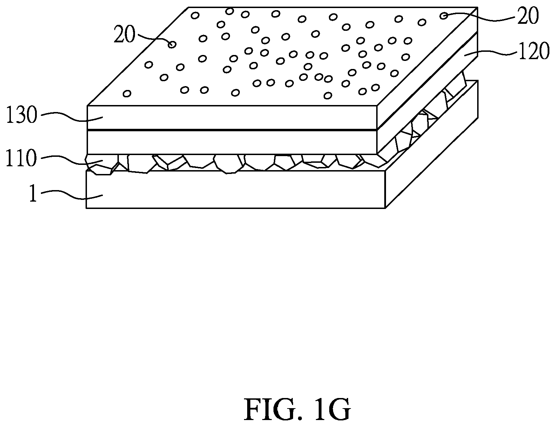

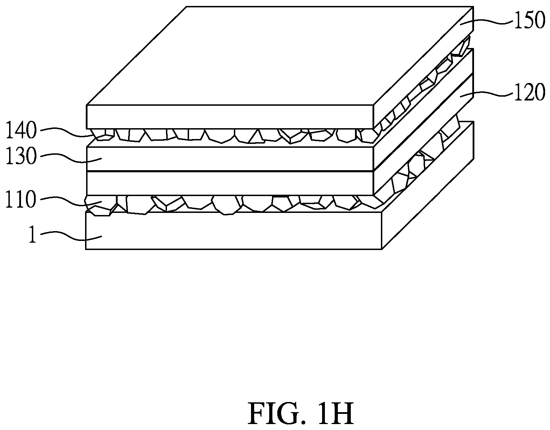

Next, a second significant lattice modulation is performed in the epitaxial structure layout. Specifically, a gallium-containing transition layer 140 is formed on the first buffer layer 130. Referring to FIG. 1G and FIG. 1H, ammonia (NH₃) and trimethylgallium (TMGa) gases are introduced using MOCVD to nucleate a plurality of gallium-containing seeds 20 uniformly distributed on the surface of the first buffer layer 130. These gallium-containing seeds 20 are specifically gallium nitride seeds. Then, at a low temperature of 400 to 600°C, the gallium-containing seeds 20 continue to grow, increasing their volume. Subsequently, similar "3D growth" and "2D growth" stages as described earlier occur, gradually forming block-like gallium-containing three-dimensional structures (not shown) on the first buffer layer 130 from the gallium-containing seeds, further forming a gallium-containing transition layer 140. This gallium-containing transition layer 140 comprises a gallium-containing three-dimensional structure formed on the first buffer layer and a gallium-containing two-dimensional structure (not shown) partially transitioned from the growth of the gallium-containing three-dimensional structure, forming a flat surface. Specifically, the gallium-containing transition layer 140 is a gallium nitride transition layer with a total thickness of 10 to 20 nanometers (nm), allowing the lattice of aluminum gallium nitride in the buffer layer to transition from a three-dimensional gallium nitride structure to a two-dimensional gallium nitride structure, once again significantly adjusting lattice mismatch and relieving corresponding internal stress.

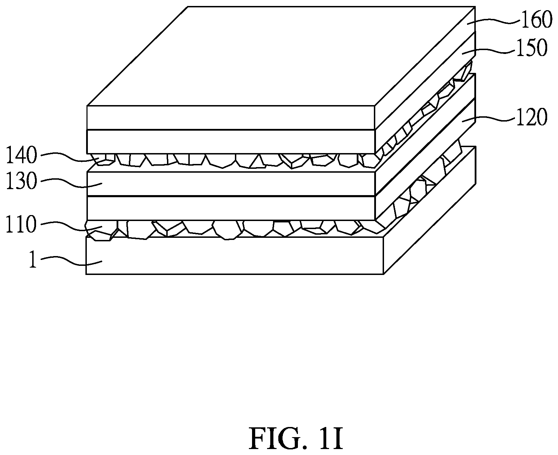

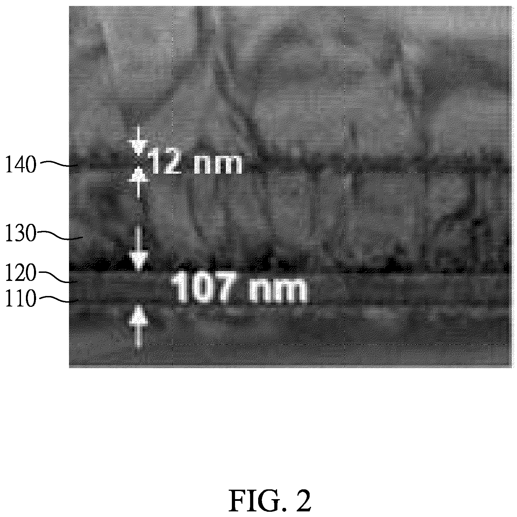

Continuing with FIG. 1H, a gallium-containing homogeneous layer 150 is grown on the flat surface of the gallium-containing two-dimensional structure in the gallium-containing transition layer 140. This gallium-containing homogeneous layer is specifically a gallium nitride layer with a thickness of at least 30 to 300 nanometers (nm) or even thicker, further reducing the number of defects in the gallium nitride material. Referring to FIG. 1I, a second buffer layer 160 is then formed on the gallium-containing homogeneous layer 150 to further modulate internal stress. Similar to the first buffer layer 130, the second buffer layer 160 may be a bulk structure or a layered stack structure, such as a layered stack made by aluminum (Al), gallium (Ga), and nitrogen (N) in varying proportions. Specifically, it may be a superlattice structure alternating stacked between high-bandgap materials (e.g., aluminum nitride or high-aluminum-content aluminum gallium nitride) and low-bandgap materials (e.g., gallium nitride or low-aluminum-content aluminum gallium nitride), with a total thickness of 20 to 5000 nanometers (nm), further reducing internal stress and defect density caused by lattice mismatch. Referring to FIG. 2, a magnified scanning electron microscope (SEM) image of a cross-section of an epitaxial structure according to the present invention is shown. The total thickness of the aluminum-containing transition layer 110 and the aluminum-containing homogeneous layer 120 is approximately 107 nanometers (nm), and the total thickness of the gallium-containing transition layer 140 is approximately 12 nanometers (nm). Clearly, the number of lattice cracks above the gallium-containing transition layer 140 is significantly reduced compared to below it. Unlike traditional superlattice structures that use small-scale lattice modulation stacking, FIG. 2 clearly demonstrates that two transition layers of different materials (e.g., aluminum nitride and gallium nitride) transitioning from three-dimensional to two-dimensional structures can effectively achieve significant lattice mismatch modulation.

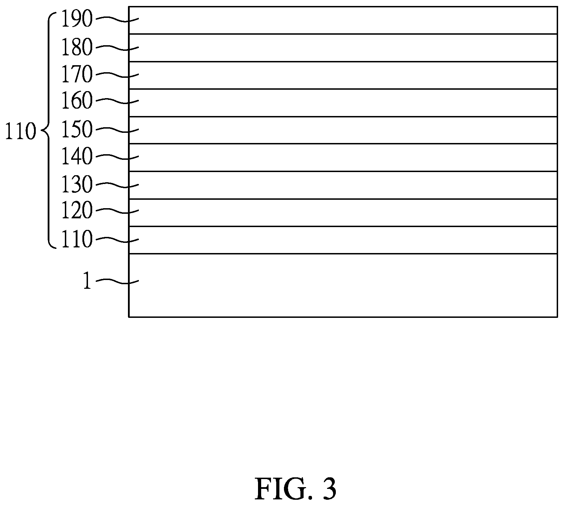

The aforementioned layout of at least two transition layers of different materials transitioning from three-dimensional to two-dimensional structures in the epitaxial structure of a power device is provided for illustrative purposes only. In practical applications, depending on the need to modulate lattice stress in the power device, the process steps shown in FIG. 1G to FIG. 1I may be repeated until the quality of the gallium nitride epitaxial film meets the specifications set for the power device. The quality of the epitaxial film can be evaluated based on criteria such as the full width at half maximum (FWHM) of the X-ray rocking curve (XRC) <1012> plane of a gallium nitride epitaxial layer with 1 micrometer being less than 1000 arc seconds, serving as a basis for determining whether to repeat the process steps shown in FIG. 1G to FIG. 1I. For example, as shown in FIG. 3, the epitaxial structure 100 on the substrate 1 includes three transition layers (110, 140, 170) transitioning from three-dimensional to two-dimensional structures to further relieve lattice internal stress and reduce lattice dislocations. Specifically, in addition to the structure shown in FIG. 1I, it further includes a gallium-containing transition layer 170, a gallium-containing homogeneous layer 180, and a third buffer layer 190 grown repeatedly on the second buffer layer 160. The materials corresponding to each epitaxial layer can refer to the foregoing description and are not repeated here.

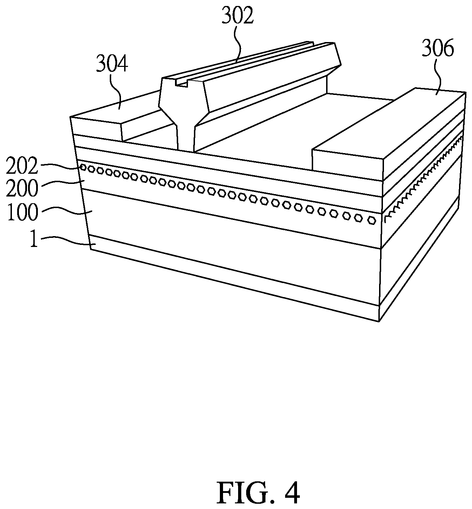

Referring to FIG. 4, a schematic diagram of a power device specifically applying the epitaxial structure of the present invention is shown. Specifically, the power device in FIG. 4 is a high electron mobility transistor, comprising a substrate 1, an epitaxial structure 100 as described above, a channel layer 200 on the epitaxial structure 100, and a gate 302, a source 304, and a drain 306 on the channel layer 200, wherein a two-dimensional electron gas (2DEG) channel 202 is present in the channel layer 200 near the upper barrier layer. In addition, the epitaxial structure of the present invention can be applied to other power devices, such as Schottky diodes, metal-oxide-semiconductor field-effect transistors (MOSFETs), junction field-effect transistors (JFETs), insulated-gate bipolar transistors (IGBTs), or light-emitting diodes (LEDs).

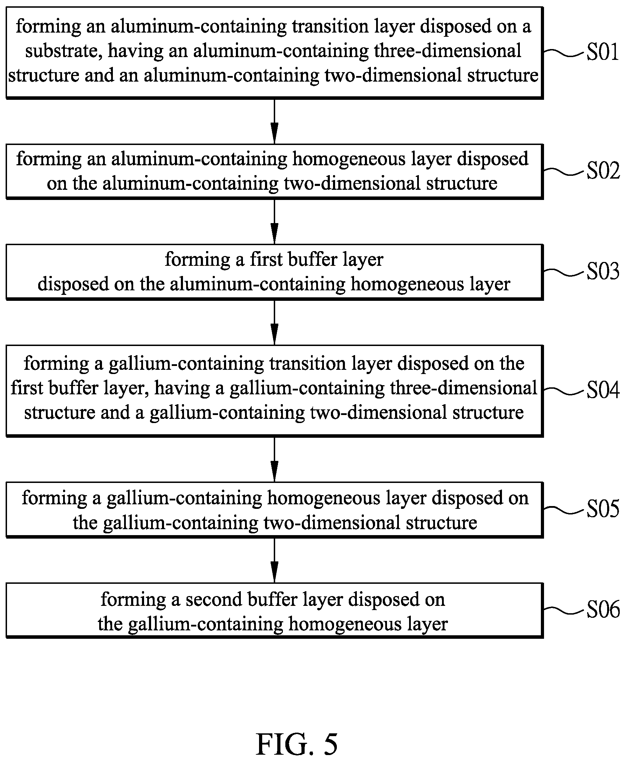

Referring to FIG. 5, a schematic diagram of the process steps for manufacturing the epitaxial structure of the present invention is shown. First, in step S01, an aluminum-containing transition layer is formed on a substrate, comprising an aluminum-containing three-dimensional structure and an aluminum-containing two-dimensional structure, wherein the aluminum-containing three-dimensional structure is formed on the substrate and grown to partially transition into the aluminum-containing two-dimensional structure. Next, in step S02, an aluminum-containing homogeneous layer is formed on the aluminum-containing two-dimensional structure. In step S03, a first buffer layer is formed on the aluminum-containing homogeneous layer. Then, in step S04, a gallium-containing transition layer is formed on the first buffer layer, comprising a gallium-containing three-dimensional structure and a gallium-containing two-dimensional structure, wherein the gallium-containing three-dimensional structure is formed on the first buffer layer and grown to partially transition into the gallium-containing two-dimensional structure. In step S05, a gallium-containing homogeneous layer is formed on the gallium-containing two-dimensional structure. Finally, in step S06, a second buffer layer is formed on the gallium-containing homogeneous layer. Descriptions of the related components can refer to the foregoing content and are not repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. An epitaxial structure, comprising:
an aluminum-containing transition layer disposed on a substrate, the aluminum-containing transition layer having an aluminum-containing three-dimensional structure and an aluminum-containing two-dimensional structure, wherein the aluminum-containing three-dimensional structure is formed on the substrate and grown to partially transition into the aluminum-containing two-dimensional structure;
an aluminum-containing homogeneous layer disposed on the aluminum-containing two-dimensional structure;
a first buffer layer disposed on the aluminum-containing homogeneous layer;
a gallium-containing transition layer disposed on the first buffer layer, the gallium-containing transition layer having a gallium-containing three-dimensional structure and a gallium-containing two-dimensional structure, wherein the gallium-containing three-dimensional structure is formed on the first buffer layer and grown to partially transition into the gallium-containing two-dimensional structure;
a gallium-containing homogeneous layer disposed on the gallium-containing two-dimensional structure; and
a second buffer layer, disposed on the gallium-containing homogeneous layer.

2. The epitaxial structure of claim 1, further comprising a plurality of aluminum-containing seeds disposed on the substrate, wherein the aluminum-containing three-dimensional structure is grown and formed from the aluminum-containing seeds.

3. The epitaxial structure of claim 2, wherein each of the aluminum-containing seeds is an aluminum nitride (AlN) seed.

4. The epitaxial structure of claim 3, wherein the aluminum-containing transition layer is an aluminum nitride transition layer, and a thickness of the aluminum nitride transition layer is between 10 and 20 nanometers (nm), preferably wherein the aluminum-containing homogeneous layer is an aluminum nitride layer, and a thickness of the aluminum nitride layer is between 30 and 300 nanometers (nm).

5. The epitaxial structure of any of the previous claims, wherein the material of the first buffer layer is made by aluminum (Al), gallium (Ga), and nitrogen (N), and a thickness of the first buffer layer is between 20 and 5000 nanometers (nm).

6. The epitaxial structure of any of the previous claims, further comprising a plurality of gallium-containing seeds disposed on the first buffer layer, wherein the gallium-containing three-dimensional structure is grown and formed from the gallium-containing seeds.

7. The epitaxial structure of the previous claim, wherein each of the gallium-containing seeds is a gallium nitride (GaN) seed.

8. The epitaxial structure of the previous claim, wherein the gallium-containing transition layer is a gallium nitride transition layer, and a thickness of the gallium nitride transition layer is between 10 and 20 nanometers (nm), preferably wherein the gallium-containing homogeneous layer is a gallium nitride layer, and a thickness of the gallium nitride layer is between 30 and 300 nanometers (nm).

9. The epitaxial structure of any of the previous claim, wherein the material of the second buffer layer is made by aluminum (Al), gallium (Ga), and nitrogen (N), and a thickness of the second buffer layer is between 20 and 5000 nanometers (nm).

10. A power device, comprising:
a substrate;
an epitaxial structure as claimed in any of the previous claims, disposed on the substrate; and
a channel layer disposed on the epitaxial structure, wherein the channel layer has a two-dimensional electron gas (2DEG) channel therein.

11. A manufacturing method of an epitaxial structure, comprising:
forming an aluminum-containing transition layer disposed on a substrate, the aluminum-containing transition layer having an aluminum-containing three-dimensional structure and an aluminum-containing two-dimensional structure, wherein the aluminum-containing three-dimensional structure is formed on the substrate and grown to partially transition into the aluminum-containing two-dimensional structure;
forming an aluminum-containing homogeneous layer disposed on the aluminum-containing two-dimensional structure;
forming a first buffer layer disposed on the aluminum-containing homogeneous layer;
forming a gallium-containing transition layer disposed on the first buffer layer, the gallium-containing transition layer having a gallium-containing three-dimensional structure and a gallium-containing two-dimensional structure, wherein the gallium-containing three-dimensional structure is formed on the first buffer layer and grown to partially transition into the gallium-containing two-dimensional structure;
forming a gallium-containing homogeneous layer disposed on the gallium-containing two-dimensional structure; and
forming a second buffer layer, disposed on the gallium-containing homogeneous layer.

12. The manufacturing method of an epitaxial structure of the previous claim, further comprising a step of providing a plurality of aluminum nitride seeds disposed on the substrate, wherein the aluminum-containing three-dimensional structure is grown and formed from the aluminum nitride seeds.

13. The manufacturing method of an epitaxial structure of the previous claim, wherein the step of forming an aluminum-containing transition layer is to form an aluminum nitride transition layer, and a thickness of the aluminum nitride transition layer is between 10 and 20 nanometers (nm), preferably wherein the step of forming an aluminum-containing homogeneous layer is to form an aluminum nitride layer, and a thickness of the aluminum nitride layer is between 30 and 300 nanometers (nm).

14. The manufacturing method of an epitaxial structure of any of the three previous claims, further comprising a step of providing a plurality of gallium nitride seeds disposed on the first buffer layer, wherein the gallium-containing three-dimensional structure is grown and formed from the gallium nitride seeds.

15. The manufacturing method of an epitaxial structure of the previous claim, wherein the step of forming a gallium-containing transition layer is to form a gallium nitride transition layer, and a thickness of the gallium nitride transition layer is between 10 and 20 nanometers (nm), preferably wherein the step of forming a gallium-containing homogeneous layer is to form a gallium nitride layer, and a thickness of the gallium nitride layer is between 30 and 300 nanometers (nm).
